(19)

Europäisches
Patentamt
European
Patent Office
Office européen
des brevets

(11) **EP 2 305 763 A1**

(12) **EUROPEAN PATENT APPLICATION**

(43) Date of publication:
06.04.2011 Bulletin 2011/14

(51) Int Cl.:
*C09J 7/02* (2006.01)

(21) Application number: 10177518.7

(22) Date of filing: 20.09.2010

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**
Designated Extension States:
**BA ME RS**

(30) Priority: 30.09.2009 JP 2009226121

(71) Applicant: Nitto Denko Corporation
Ibaraki-shi,
Osaka 567-8680 (JP)

(72) Inventors:
• **Higashibeppu, Yuki**
**Ibaraki-shi Osaka 567-8680 (JP)**
• **Takahashi, Tomokazu**
**Ibaraki-shi Osaka 567-8680 (JP)**
• **Asai, Fumiteru**
**Ibaraki-shi Osaka 567-8680 (JP)**

(74) Representative: **Grünecker, Kinkeldey,
Stockmair & Schwanhäusser
Anwaltssozietät
Leopoldstrasse 4
80802 München (DE)**

(54) **Pressure-sensitive adhesive sheet for retaining elements and method of producing elements**

(57)    A pressure-sensitive adhesive sheet for retaining elements according to an embodiment of the present invention includes a base material layer and a pressure-sensitive adhesive layer provided on the base material layer and capable of being cured by an external stimulus. A crack-generating elongation represented by the following equation in a case where the pressure-sensitive adhesive sheet is elongated in a state where the pressure-sensitive adhesive layer is cured is larger than 115%.

```
Crack-generating   elongation   (%)=[(a  length  of  the pressure-sensitive adhesive sheet when a crack is generated in a surface of the pressure-sensitive adhesive layer)-(an original length of the pressure-sensitive adhesive sheet)]/(the original length of the pressure-sensitive adhesive sheet)×100.
```

**EP 2 305 763 A1**

Fig.1

100

~13
~12
~11

**Description**

BACKGROUND OF THE INVENTION

1. Field of the Invention

The present invention relates to a pressure-sensitive adhesive sheet for retaining elements and a method of producing elements involving the use of the pressure-sensitive adhesive sheet.

2. Description of the Related Art

Semiconductor elements are generally produced by singulating a semiconductor wafer that has undergone a grinding step into chip shapes. To be specific, the semiconductor wafer is produced so as to have a large diameter. After that, the wafer is subjected to back grinding so as to have a predetermined thickness. Further, the back surface of the wafer is subjected to a treatment (such as etching or polishing) as required. Next, the wafer is subjected to dicing. In the dicing step, the wafer is fixed onto a pressure-sensitive adhesive sheet for dicing in advance before the dicing is performed so that the semiconductor elements may be singulated. After that, the pressure-sensitive adhesive sheet is expanded so that gaps between the elements may be expanded. Then, the singulated semiconductor elements are picked up. Thus, the singulated semiconductor elements are recovered. The following case is permitted. That is, after the pressure-sensitive adhesive sheet has been expanded once, the semiconductor elements on the expanded pressure-sensitive adhesive sheet are transferred onto another pressure-sensitive adhesive sheet, and expansion is performed again before the pickup is performed. The following case is also permitted. That is, a set of the expansion and the transfer is repeated a plurality of times before the pickup is performed.

A film made of a soft polyvinyl chloride is often used as a base material layer for the pressure-sensitive adhesive sheet to be used upon recovery of the singulated semiconductor elements (which may hereinafter be referred to as "chips") described above in order that expandability may be secured. In addition, a pressure-sensitive adhesive layer is often used for the sheet. In recent years, however, the thinning and weakening of wafers have been progressing, and hence the use of a pressure-sensitive adhesive sheet having the pressure-sensitive adhesive layer involves such problems as described below. When the adhesion of the sheet is strong, the sheet is excellent in chip-retaining performance, but it becomes difficult to perform the pickup. When the adhesion is weak, the pickup can be easily performed, but the sheet is poor in chip-retaining performance, thereby causing, for example, the release and drop of the chips.

To cope with the above-mentioned problems, the use of a UV-curable pressure-sensitive adhesive sheet as a pressure-sensitive adhesive sheet having both functions, i.e., pressure-sensitive adhesiveness for retaining chips and light releasability at the time of the pickup has become widespread. With the UV-curable pressure-sensitive adhesive sheet, the chips can be strongly retained. In addition, when the sheet is irradiated with UV light so that its pressure-sensitive adhesive layer may be cured, its adhesion reduces. As a result, the chips can be easily picked up (Japanese Examined Patent Publication No. Hei 6-16524 and Japanese Examined Patent Publication No. Hei 7-105367). In addition, the following pressure-sensitive adhesive sheet has been disclosed as such UV-curable pressure-sensitive adhesive sheet (Japanese Patent Application Laid-open No. 2005-235795). That is, the sheet has a pressure-sensitive adhesive layer having a rupture elongation of 12 to 50% in order that the cracking of the pressure-sensitive adhesive layer at the time of the expansion and an adhesive residue at the time of the pickup may be alleviated.

However, with a conventional UV-curable pressure-sensitive adhesive sheet, the chips are released from the surface of the pressure-sensitive adhesive layer to float at the time of the expansion of the pressure-sensitive adhesive sheet. As a result, chips may scatter at the time of the pickup owing to an impact such as a thrust with a needle.

SUMMARY OF THE INVENTION

The present invention has been made to solve the above-mentioned conventional problems, and an object of the present invention is to provide such a pressure-sensitive adhesive sheet for retaining elements that the elements do not float when expansion is performed in a state where the elements are retained.

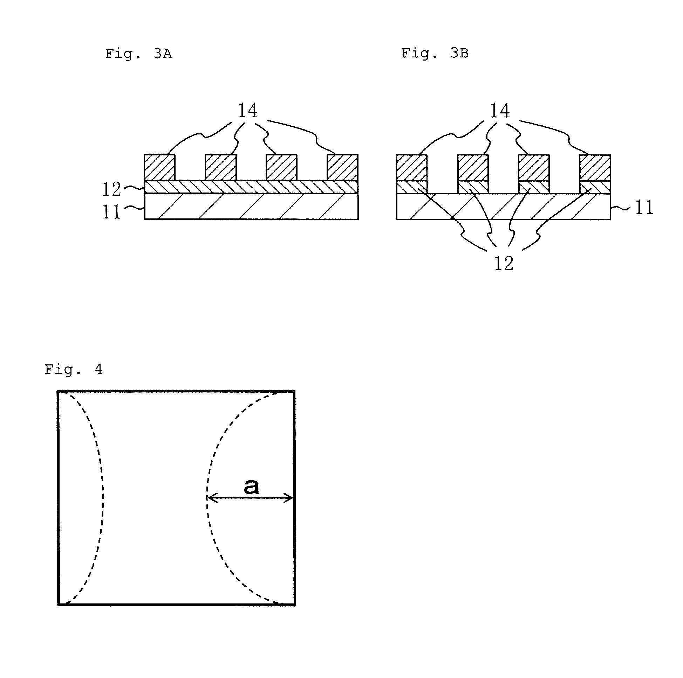

Detailed investigations conducted by the inventors of the present invention have found that the chip floating phenomenon is observed when a pressure-sensitive adhesive layer **12** is present at a gap between a plurality of chips **14** as illustrated in FIG. **3A** in the step of expanding a pressure-sensitive adhesive sheet (expanding step) and that a cause for the phenomenon is a crack in the surface of the pressure-sensitive adhesive layer resulting from the expansion of the pressure-sensitive adhesive sheet. To be specific, the following assumption can be made. That is, when the pressure-sensitive adhesive sheet in a state of retaining the plurality of chips is expanded, the pressure-sensitive adhesive layer and a base material layer at a gap portion between the chips are expanded. In this case, when the expansion amount of the pressure-sensitive adhesive sheet is large, a crack is generated in the pressure-sensitive adhesive layer at the gap portion between the chips. The expansion amounts become non-uniform at the portion where the crack is generated and a portion where the crack is not generated, and stresses to be applied to these portions also become non-uniform. The pressure-sensitive adhesive sheet deforms to a large extent at a portion where a large stress is applied (stress concentration portion). As a result, a chip is released from the surface of the sheet, and hence floating occurs. In addition, at the time of the expansion of the pressure-sensitive adhesive sheet, a stress concentrates on the gap between the chips. As a result, the gap is expanded at a larger rate of expansion than the rate of expansion of the entire pressure-sensitive adhesive sheet. Accordingly, even when a conventional pressure-sensitive adhesive sheet whose pressure-sensitive adhesive layer has a rupture elongation of 12% to 50% is used, in the case where the pressure-sensitive adhesive layer is present at the gap portion, a crack is generated in the pressure-sensitive adhesive layer at the gap portion.

The inventors of the present invention have made extensive studies on the basis of the above-mentioned findings. As a result, the inventors have found the following. That is, when such a pressure-sensitive adhesive sheet that no crack is generated in the surface of a pressure-sensitive adhesive layer even when the sheet is elongated to a predetermined length after the pressure-sensitive adhesive layer has been cured is used, the sheet can be expanded without the generation of any crack in the pressure-sensitive adhesive layer at a gap between chips in an expanding step. As a result, the chips are prevented from floating, and hence can be favorably picked up. Thus, the inventors have completed the present invention.

According to one aspect of the present invention, a pressure-sensitive adhesive sheet for retaining elements is provided. The pressure-sensitive adhesive sheet includes a base material layer and a pressure-sensitive adhesive layer provided on the base material layer and capable of being cured by an external stimulus. A crack-generating elongation represented by the following equation in a case where the pressure-sensitive adhesive sheet is elongated in a state where the pressure-sensitive adhesive layer is cured is larger than 115%.

```
Crack-generating      elongation      (%)=[(a      length      of      the
pressure-sensitive adhesive sheet when a crack is generated in a
surface  of  the  pressure-sensitive  adhesive  layer)-(an  original
length of the pressure-sensitive adhesive sheet)]/(the original
length of the pressure-sensitive adhesive sheet)×100.
```

In one embodiment of the present invention, the pressure-sensitive adhesive layer includes an active energy ray-curable pressure-sensitive adhesive layer.

In another embodiment of the present invention, a material of which the pressure-sensitive adhesive layer is formed contains a base polymer, and 1 to 150 parts by weight of at least one of an active energy ray-curable monomer and an active energy ray-curable oligomer with respect to 100 parts by weight of the base polymer.

In still another embodiment of the present invention, a material of which the pressure-sensitive adhesive layer is formed contains a (meth)acrylic polymer having a polymerizable carbon-carbon double bond.

In still another embodiment of the present invention, the pressure-sensitive adhesive sheet is used for retaining a plurality of singulated elements in an expanding step.

In still another embodiment of the present invention, the pressure-sensitive adhesive layer is present at a gap between the plurality of singulated elements.

In still another embodiment of the present invention, the elements include elements singulated by laser dicing.

In still another embodiment of the present invention, the elements include elements transferred after the singulation.

In still another embodiment of the present invention, the elements include semiconductor elements.

According to another aspect of the present invention, a method of producing element is provided. The method of producing elements includes attaching a substrate on which a plurality of elements have been formed to the surface of the pressure-sensitive adhesive layer of the pressure-sensitive adhesive sheet for retaining elements, subjecting the substrate to dicing to singulate the plurality of elements and expanding the pressure-sensitive adhesive sheet for retaining elements to expand a gap between the plurality of singulated elements.

The another method of producing elements include transferring a plurality of elements that have already been singulated onto the surface of the pressure-sensitive adhesive layer of the pressure-sensitive adhesive sheet for retaining elements and expanding the pressure-sensitive adhesive sheet for retaining elements to expand a gap between the plurality of singulated elements.

In one embodiment of the present invention, the dicing includes laser dicing.

The pressure-sensitive adhesive sheet for retaining elements of the present invention can be expanded without the generation of any crack in the pressure-sensitive adhesive layer because the crack-generating elongation in a state where the pressure-sensitive adhesive layer is cured is larger than 115%. As a result, the deformation of the pressure-sensitive adhesive layer at the time of the expansion becomes uniform as compared with that in the case where a crack is generated, and hence the elements retained on the surface of the sheet can be prevented from floating.

BRIEF DESCRIPTION OF THE DRAWINGS

In the accompanying drawings:

FIG. **1** is a schematic sectional diagram of a pressure-sensitive adhesive sheet for retaining elements according to a preferred embodiment of the present invention;

FIG. **2** is a photograph showing an example of a state where a crack is generated at the time of the measurement of a crack-generating elongation;

FIG. **3A** is a diagram illustrating an example of a state where a pressure-sensitive adhesive layer is present at a gap between chips and FIG. **3B** is a diagram illustrating an example of a state where the pressure-sensitive adhesive layer is not present at any gap between the chips; and

FIG. **4** is a diagram illustrating a judgement criterion for chip floating.

DETAILED DESCRIPTION OF THE PREFERRED EMBODIMENTS

A. Pressure-sensitive adhesive sheet for retaining elements

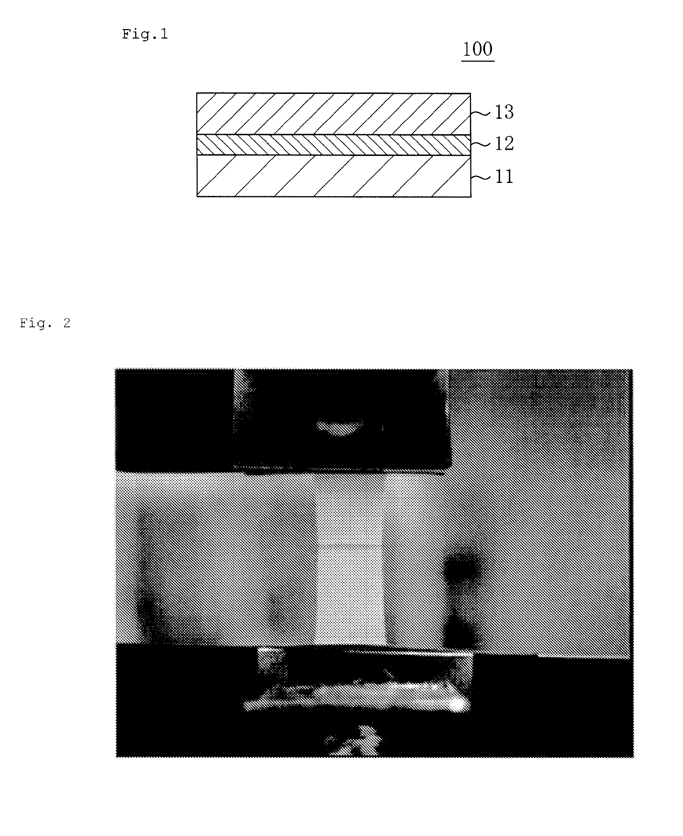

FIG. **1** is a schematic sectional diagram of a pressure-sensitive adhesive sheet for retaining elements according to a preferred embodiment of the present invention. A pressure-sensitive adhesive sheet **100** for retaining elements has a base material layer **11** and a pressure-sensitive adhesive layer **12** provided on the base material layer and capable of being cured by an external stimulus. The pressure-sensitive adhesive sheet **100** for retaining elements may further have, on the pressure-sensitive adhesive layer **12,** a separator **13** that protects the surface of the layer before its use. Although the pressure-sensitive adhesive sheet **100** for retaining elements has the pressure-sensitive adhesive layer **12** only on one surface of the base material layer **11,** the present invention is not limited to the foregoing, and for example, the pressure-sensitive adhesive layer **12** may be provided on each of both surfaces of the base material layer **11.**

In the present invention, the crack-generating elongation of the above-mentioned pressure-sensitive adhesive sheet for retaining elements in the case where the sheet is elongated in a state where the pressure-sensitive adhesive layer is cured is larger than 115%, preferably 120% or more, or more preferably 130 to 1000%. When the crack-generating elongation is 115% or less, a crack is generated in the surface of the pressure-sensitive adhesive layer at the time of the expansion of the pressure-sensitive adhesive sheet, and a chip floats at a stress concentration portion in some cases. In addition, curing that provides a crack-generating elongation in excess of 1000% may be unable to impart sufficient light releasability because the adhesion of a curable pressure-sensitive adhesive layer generally reduces owing to the curing of the layer.

The above-mentioned crack-generating elongation can be determined as described below. First, the pressure-sensitive adhesive sheet (70 mm×20 mm) whose pressure-sensitive adhesive layer has been cured is mounted on a universal tensile tester so that a chuck-to-chuck distance may be 20 mm. Next, the pressure-sensitive adhesive sheet is pulled at room temperature and a tension speed of 50 mm/min until a crack is generated in the surface of its pressure-sensitive adhesive layer. Then, the length of the pressure-sensitive adhesive sheet at the time point when the crack is generated is measured. The crack-generating elongation is determined by substituting the resultant value into the following equation. The phrase "time point when the crack is generated" as used herein refers to the time point when the crack generated in the surface of the pressure-sensitive adhesive layer reaches both sides stretching in the direction in which the pressure-sensitive adhesive sheet is pulled (time point when the surface of the pressure-sensitive adhesive layer is divided into two pieces by the crack). As shown in FIG. **2,** the crack is typically generated in the surface of the pressure-sensitive adhesive layer in a direction substantially perpendicular to the pulling direction in a linear fashion, and can be observed. Accordingly, whether or not the crack is generated can be observed with the eyes.

Crack-generating elongation (%)=[(the length of the pressure-sensitive adhesive sheet when a crack is generated in the surface of the pressure-sensitive adhesive layer)-(the original length of the pressure-sensitive adhesive sheet)]/(the original length of the pressure-sensitive adhesive sheet)$\times$100

Elements retained by the pressure-sensitive adhesive sheet for retaining elements of the present invention are preferably, for example, semiconductor elements or semiconductor packages formed from silicon and gallium-arsenide. Hereinafter, an embodiment in which the elements are semiconductor elements is described in detail. However, the pressure-sensitive adhesive sheet for retaining elements of the present invention can be used for any elements produced by a production method including the above-mentioned expanding step (e.g., various elements such as optical elements and piezoelectric elements formed from ruby, glass, and ceramic).

The shape of the pressure-sensitive adhesive sheet for retaining elements of the present invention can be any appropriate shape depending on applications and the like. For example, the pressure-sensitive adhesive sheet for retaining elements can be of a sheet shape or a roll shape. In addition, when the sheet is used as a pressure-sensitive adhesive sheet for dicing upon dicing of a semiconductor wafer, the sheet is suitably cut into a predetermined shape in advance before its use.

B. Base material layer

The base material layer **11** functions as a strength parent body for the pressure-sensitive adhesive sheet for retaining elements of the present invention. The base material layer preferably has a rupture elongation of 115% or more. The expanding step can be performed without a hitch as long as the rupture elongation of the base material layer is 115% or more. The rupture elongation can be measured by the following method with reference to JIS Z0237. First, a test piece having a width of 10 mm and a length of 100 mm is produced. The test piece is mounted on a tester so that a grip distance may be 50 mm. Then, the test piece is pulled at a speed of 300 mm/min, and an elongation until the test piece is cut is measured. The elongation is calculated from the following equation. It should be noted that the measurement is conducted on three test pieces and the average of the resultant values is defined as the rupture elongation.

$$E = (L_1 - L_0) / L_0 \times 100$$

(E: the elongation (%), $L_0$: the initial grip distance (mm), $L_1$: a grip distance at the time of the cutting (mm))

Any appropriate base material can be adopted as a base material of which the base material layer is constituted as long as the sheet can be expanded in the expanding step without a hitch. When the pressure-sensitive adhesive layer laminated on the base material layer is an active energy ray-curable pressure-sensitive adhesive layer, a base material having such nature as to transmit at least part of active energy rays can be preferably used.

Specific examples of the base material include: fiber-based base materials such as a woven fabric and a nonwoven fabric; paper-based base materials; metal-based base materials such as a metal foil and a metal plate; and plastic-based base materials such as a resin film and a resin sheet. Of those, the plastic-based base materials can each be preferably used. This is because the plastic-based base materials each have high elongating performance.

Examples of the forming material for the plastic-based base material include: polyolefins such as low-density polyethylene, linear polyethylene, medium-density polyethylene, high-density polyethylene,very-low-density polyethylene, random-copolymerized polypropylene, block-copolymerized polypropylene, homo polypropylene, polybutene, and polymethylpentene; ethylene-vinyl acetate copolymer; an ionomer resin; ethylene-(meth)acrylate copolymer; ethylene-(meth)acrylate ester (random, alternating) copolymer; ethylene-butene copolymer; ethylene-hexene copolymer; polyurethane; polyesters such as polyethylene terephthalate; polyimide; polyetherketone; polystyrene; polyvinyl chloride; polyvinylidene chloride; a fluorine resin; a silicone resin; a cellulose-based resin; and polymers such as cross-linking products thereof. As the forming material, there may be used the above-mentioned polymers to which a functional group, a functional monomer, or amodifyingmonomer is grafted, as required. Inaddition, as the forming material, one kind of the above-mentioned materials may be used alone, or two or more kinds thereof appropriately selected may be used in combination.

The base material layer may be of a single-layer structure formed of a single base material, or may be of a multilayer structure in which a plurality of base materials are laminated. When the base material layer is of a multilayer structure, the respective layers may be base materials formed from the same material, or may be base materials formed from different materials. When the base materials are each a plastic-based base material, the plastic-based base material may be used without being stretched, or may be subjected to a uniaxial or biaxial stretching treatment as required.

In the base material layer, a deposited layer of a conductive substance formed of, for example, a metal or an alloy, or an oxide of the metal or alloy can be provided on the above-mentioned base material for imparting an antistatic ability. The deposited layer has a thickness of, for example, about 30 to 500 Å.

The thickness of the base material layer can be set to any appropriate value depending on applications and the like. The thickness of the base material layer is generally 10 to 300 $\mu$m, or preferably about 30 to 200 $\mu$m.

Any appropriate method can be adopted as a method of producing the base material layer. For example, when the base material layer is a plastic film layer, a production method such as calender film formation, casting film formation, inflation extrusion, or T-die extrusion can be suitably employed. When the base material layer has a multilayer structure, a conventional film lamination method such as a co-extrusion method or a dry lamination method can be adopted on condition that any such polymer as described above is used.

The surface of the base material layer may be subjected to a surface treatment for improving, for example, adhesiveness with, or retentivity for, an adjacent layer as required. Examples of the surface treatment include chemical or physical treatments such as a chromic acid treatment, exposure to ozone, exposure to a flame, exposure to a high-voltage electric shock, an ionizing radiation treatment, a mat treatment, a corona discharge treatment, a primer treatment, and a cross-linking treatment.

C. Pressure-sensitive adhesive layer

The pressure-sensitive adhesive layer **12** has such nature as to be cured by an external stimulus. With the nature, the pressure-sensitive adhesive layer exerts high pressure-sensitive adhesiveness so as to be capable of strongly retaining chips before its curing, and can exert light releasability after its curing with the external stimulus because the pressure-sensitive adhesiveness reduces. Examples of the external stimulus include irradiation with active energy rays such as X-rays, UV light, and particle rays, and heating. The pressure-sensitive adhesive layer is preferably an active energy ray-curable pressure-sensitive adhesive layer that is cured by irradiation with active energy rays.

An active energy ray-curable pressure-sensitive adhesive containing a base polymer, and at least one of an active energy ray-curable monomer and an active energy ray-curable oligomer (which may hereinafter be referred to as "addition type, active energy ray-curable pressure-sensitive adhesive"), and an active energy ray-curable pressure-sensitive adhesive containing a polymer having a polymerizable carbon-carbon double bond as a base polymer (which may hereinafter be referred to as "base polymer type, active energy ray-curable pressure-sensitive adhesive") are each preferably exemplified as a material of which the active energy ray-curable pressure-sensitive adhesive layer is formed.

Any appropriate polymer can be adopted as the base polymer in the addition type, active energy ray-curable pressure-sensitive adhesive as long as the layer can exert pressure-sensitive adhesiveness. Specific examples of the base polymer include a (meth) acrylic polymer and a rubber-based polymer. The base polymer is preferably a (meth) acrylic polymer. It should be noted that the term "(meth)acrylic" as used in the specification means that both terms "acrylic" and "methacrylic" are included.

Examples of the above-mentioned (meth)acrylic polymer preferably include a polymer having an alkyl (meth) acrylate ester as a monomer unit. Examples of an alkyl group of the alkyl (meth) acrylate ester include preferably a straight-chain alkyl group, a branched-chain alkyl group, or a cyclic alkyl group each having 1 to 20 carbon atoms, more preferably a straight-chain alkyl group, a branched-chain alkyl group, or a cyclic alkyl group each having 1 to 10 carbon atoms, or particularly preferably a methyl group, an ethyl group, a butyl group, a 2-ethylhexyl group, and an octyl group. The above-mentioned (meth) acrylic polymer may be a homopolymer which is obtained by using only one kind of alkyl (meth)acrylate ester, or may be a copolymer which is obtained by using two or more kinds of alkyl (meth)acrylate ester.

The above-mentioned (meth)acrylic polymer may include as needed, for the purpose of improving cohesive strength, heat resistance, or the like, a monomer unit corresponding to another monomer which is copolymerizable with the above-mentioned alkyl (meth)acrylate ester. Examples of the another copolymerizable monomer include: carboxyl group-containing monomers such as acrylic acid, methacrylic acid, carboxyethyl (meth) acrylate, carboxypentyl (meth) acrylate, itaconic acid, maleic acid, fumaric acid, and crotonic acid; acid anhydride monomers such as maleic acid anhydride and itaconic acid anhydride; hydroxyl group-containing monomers such as 2-hydroxyethyl (meth)acrylate, 2-hydroxypropyl (meth) acrylate, 4-hydroxybutyl (meth) acrylate, 6-hydroxyhexyl (meth)acrylate, 8-hydroxyoctyl (meth) acrylate, 10-hydroxydecyl (meth)acrylate, 12-hydroxylauryl (meth)acrylate, and (4-hydroxymethylcyclohexyl)methyl (meth)acrylate; monomers containing nitrogen at its side chains such as (meth)acrylamide, N-hydroxymethylamide (meth)acrylate, alkylaminoalkyl (meth)acrylate esters (for example, dimethylaminoethyl methacrylate, t-butylaminoethyl methacrylate, or the like), N-vinylpyrrolidone, acryloylmolbuolin, acrylonitrile, and N,N-dimethylacrylamide; alcoxyl group-containing monomers such as methoxyethyl (meth)acrylate and ethoxyethyl (meth)acrylate; sulfonic acid group-containing monomers such as styrenesulfonic acid, allylsulfonic acid, 2-(meth)acrylamide-2-methylpropanesulfonic acid, (meth)acrylamidepropanesulfonic acid, sulfopropyl(meth)acrylate, and (meth) acryloyloxy naphtalenesulfonic acid; and phosphoric acid group-containing monomers such as 2-hydroxyethylacryloylphosphate. One kind of the other copolymerizable monomers may be used alone, or two or more kinds thereof may be used in combination.

As the another monomers which is copolymerizable with the above-mentioned alkyl (meth)acrylate ester, a polyfunctional monomer can be also used. When the polyfunctional monomer is used, a (meth)acrylic polymer having a cross-linking structure can be obtained. Examples of the polyfunctional monomer include hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa (meth)acrylate, epoxy(meth)acrylate, polyester(meth)acrylate, and urethane(meth)acrylate. One kind of the polyfunctional monomers may be used alone, or two or more kinds thereof may be used in combination.

The above-mentioned (meth)acrylic polymer may have a polymerizablecarbon-carbondoublebond. The(meth) acrylic polymer that can be used as the base polymer of the base polymer type, active energy ray-curable pressure-sensitive adhesive described above can be used as the (meth)acrylic polymer having a polymerizable carbon-carbon double bond. The polymer is described later.

The above-mentioned (meth)acrylic polymer has a weight-average molecular weight of preferably 500,000 or more, or more preferably about 800, 000 to 3,000, 000. When the weight-average molecular weight is less than 500, 000, a sufficient cohesive strength can no longer be obtained, and the contamination of chips and the like occurs in some cases. In addition, when the weight-average molecular weight exceeds 3, 000, 000, the pressure-sensitive adhesive layer is ruptured upon expansion of the pressure-sensitive adhesive sheet, and a crack is apt to be generated in some cases.

The above-mentioned (meth)acrylic polymer is obtained by polymerizing one or two or more kinds of the above-mentioned monomers. The polymerization can be performed according to any one of the modes including solution polymerization, emulsion polymerization, bulk polymerization, and suspension polymerization.

As the active energy ray-curable monomer or oligomer, there can be adopted a monomer or an oligomer having a functional group which is cross-linked by irradiation with active energy rays, such as a polymerizable carbon-carbon double bond. Examples of the monomer or oligomer having the functional group include tirmethylolpropane tri(meth) acrylate, pentaerythritol tri(meth)acrylate, dipentaerythritol hexa(meth)acrylate, tetraethylene glycol di(meth)acrylate, 1,6-hexanediol (meth)acrylate, neopentyl glycol di(meth)acrylate, an esterified product of (meth)acrylic acid and polyalcohol, an ester acrylate oligomer, 2-propenyl-3-butenyl cyanurate, isocyanurate, and an isocyanurate compound. Of those, preferred is a monomer or an oligomer containing average of 6 or more of polymerizable carbon-carbon double bonds in one molecule, such as dipentaerythritol hexa(meth)acrylate. One kind of the active energy ray-curable monomer or oligomer may be used alone, or two or more kinds thereof may be used in combination. It should be noted that the viscosity of the active energy ray-curable monomer or oligomer is not particularly limited.

The total compounding amount of the above-mentioned active energy ray-curable monomer and oligomer in the addition type, active energy ray-curable pressure-sensitive adhesive is preferably 1 to 150 parts by weight, more preferably 1 to 100 parts by weight, particularly preferably 5 to 50 parts by weight, or most preferably 10 to 40 parts by weight with respect to 100 parts by weight of the base polymer. As long as the compounding amount falls within the above-mentioned range, curing sufficiently reduces the adhesion of the pressure-sensitive adhesive layer. As a result, chips can be easily released. Further, the generation of a crack in the pressure-sensitive adhesive layer after the curing resulting from the expansion of the pressure-sensitive adhesive sheet can be prevented. On the other hand, when the compounding amount is less than 1 part by weight, the pressure-sensitive adhesive layer is not sufficiently cured by irradiation with active energy rays, and hence elements cannot be easily released in some cases. In addition, when the compounding amount exceeds 150 parts by weight, a crack is apt to be generated in the pressure-sensitive adhesive layer after the curing upon expansion of the pressure-sensitive adhesive sheet for retaining elements, and hence a desired crack-generating elongation cannot be obtained in some cases.

On the other hand, in the above-mentioned base polymer type, active energy ray-curable pressure-sensitive adhesive, the base polymer itself has such nature as to cross-link by irradiation with active energy rays. Accordingly, the addition of the above-mentioned active energy ray-curable monomer or oligomer is not necessarily needed, and is optional. In the pressure-sensitive adhesive free of the monomer or oligomer having a low molecular weight, such low-molecular component does not move over time, and hence a pressure-sensitive adhesive layer having a stable structure can be formed.

A polymer having a polymerizable carbon-carbon double bond in any one of its side chains, in its main chain, or at a terminal of its main chain can be used as the polymer having a polymerizable carbon-carbon double bond serving as the base polymer of the above-mentioned base polymer type, active energy ray-curable pressure-sensitive adhesive. Such polymer is preferably the following polymer. That is, the (meth) acrylic polymer that can be used as a base polymer in the above-mentioned addition type, active energy ray-curable pressure-sensitive adhesive is used as a basic skeleton, and a polymerizable carbon-carbon double bond is introduced to the basic skeleton. In consideration of the ease of molecular design, the polymerizable carbon-carbon double bond is preferably introduced to a side chain of the above-mentioned (meth)acrylic polymer.

The number of polymerizable carbon-carbon double bonds per molecule of the above-mentioned polymer having a polymerizable carbon-carbon double bond is preferably six or more on average. As long as the number of polymerizable carbon-carbon double bonds per molecule is six or more on average, the pressure-sensitive adhesive is sufficiently cured by irradiation with active energy rays, and hence the adhesion reduces. As a result, the chips can be easily released.

Any appropriate method can be adopted as a method of introducing a polymerizable carbon-carbon double bond to the above-mentioned (meth)acrylic polymer. A method of introducing a polymerizable carbon-carbon double bond to a side chain of the above-mentioned (meth)acrylic polymer is, for example, a method involving: copolymerizing monomers each having a functional group to synthesize a (meth)acrylic polymer having a functional group at any one of its side chains; and subjecting a compound having a functional group capable of reacting with the functional group and a polymerizable carbon-carbon double bond to a condensation or addition reaction after the synthesis while maintaining the active energy ray curability of the polymerizable carbon-carbon double bond.

A combination of the above-mentioned functional groups capable of reacting with each other is a combination of, for example, a carboxylic group and an epoxy group, a carboxylic group and an aziridyl group, or a hydroxyl group and an isocyanate group. Of those combinations of functional groups, the combination of a hydroxyl group and an isocyanate group is preferred because the reaction can be easily pursued. As long as a (meth)acrylic polymer having a polymerizable carbon-carbon double bond can be obtained by any one of those combinations of functional groups, whether each functional group is present on the (meth)acrylic polymer or the compound having a polymerizable carbon-carbon double bond presents no problems. In the combination of a hydroxyl group and an isocyanate group, it is preferred that : the (meth) acrylic polymer have a hydroxyl group; and the above-mentioned compound having a polymerizable carbon-carbon double bond have an isocyanate group.

Examples of the isocyanate compound having a polymerizable carbon-carbon double bond include methacryloyl isocyanate, 2-methacryloyloxyethyl isocyanate, and m-isopropenyl-$\alpha$, $\alpha$-dimethylbenzyl isocyanate.

Examples of the (meth) acrylic polymer having a hydroxyl group at its side chains include polymers which can be obtained by copolymerizing ether-based compounds such as the hydroxy group-containing monomer exemplified above, 2-hydroxyethyl vinyl ether, 4-hydroxybutyl vinyl ether, and diethylene glycol monovinyl ether.

In a condensation reaction between the above-mentioned isocyanate compound having a polymerizable carbon-carbon double bond and the above-mentioned (meth) acrylic polymer having hydroxyl groups at its side chains, the compounding amount of each of the isocyanate compound and the (meth)acrylic polymer can be set so that the number of moles of isocyanate groups of the isocyanate compound may be preferably 1 to 90, or more preferably 5 to 80 with respect to 100 moles of the hydroxyl groups of the (meth)acrylic polymer. As long as a ratio between the hydroxyl groups and the isocyanate groups falls within the range, the condensation reaction progresses efficiently, and hence a (meth) acrylic polymer having sufficient active energy ray curability can be obtained. On the other hand, when the number of moles of the isocyanate groups exceeds 90 with respect to 100 moles of the hydroxyl groups, a cross-link density between the polymer after the curing increases, and hence a crack is apt to be generated in the surface of the pressure-sensitive adhesive layer at the time of the expansion of the pressure-sensitive adhesive sheet for retaining elements in some cases.

The above-mentioned polymer having a polymerizable carbon-carbon double bond has a weight-average molecular weight of preferably 500,000 or more, or more preferably about 800,000 to 3, 000, 000. When the weight-average molecular weight is less than 500,000, a sufficient cohesive strength can no longer be obtained, and the contamination of chips and the like occurs in some cases. In addition, when the weight-average molecular weight exceeds 3,000,000, the pressure-sensitive adhesive layer is ruptured upon expansion of the pressure-sensitive adhesive sheet, and a crack is apt to be generated in some cases.

The above-mentioned base polymer type, active energy ray-curable pressure-sensitive adhesive may contain at least one of an active energy ray-curable monomer and an active energy ray-curable oligomer as required. Preferred examples of the active energy ray-curable monomer and oligomer include active energy ray-curable monomers and oligomers each used in the above-mentioned addition type, active energy ray-curable pressure-sensitive adhesive.

The total compounding amount of the above-mentioned active energy ray-curable monomer and oligomer in the above-mentioned base polymer type, active energy ray-curable pressure-sensitive adhesive is preferably 1 to 150 parts by weight, more preferably 1 to 100 parts by weight, particularly preferably 1 to 50 parts by weight, or most preferably 5 to 40 parts by weight with respect to 100 parts by weight of the base polymer. When the compounding amount exceeds 150 parts by weight, a crack is apt to be generated in the pressure-sensitive adhesive layer after the curing upon expansion of the pressure-sensitive adhesive sheet for retaining elements, and hence a desired crack-generating elongation cannot be obtained in some cases.

Each of the above-mentioned addition type and base polymer type, active energy ray-curable pressure-sensitive adhesives may further contain an external cross-linking agent as required. The base polymer and the external cross-linking agent react with each other in the pressure-sensitive adhesive. As a result, the base polymer is cross-linked, and hence its weight-average molecular weight can increase. Any appropriate cross-linking agent can be adopted as the external cross-linking agent. Specific examples of the external cross-linking agent include a polyisocyanate compound, an epoxy compound, an aziridine compound, a melamine resin, a urea resin, an anhydrous compound, polyamine, and a carboxyl group-containing polymer.

The compounding amount of the external cross-linking agent can be appropriately set depending on, for example, a balance with the base polymer to be cross-linked and the applications of the pressure-sensitive adhesive sheet for retaining elements. In general, the compounding amount of the external cross-linking agent is 0.1 to 10 parts by weight with respect to 100 parts by weight of the above-mentioned base polymer.

Each of the above-mentioned addition type and base polymer type, active energy ray-curable pressure-sensitive adhesives may further contain a photopolymerization initiator as required. Since the photopolymerization initiator is activated by irradiation with rays such as UV light, the photopolymerization initiator can be particularly suitably used when any such pressure-sensitive adhesive is UV-curable.

Examples of the photopolymerization initiator include: benzoinalkyl ethers such as benzoinmethyl ether, benzoisopropyl ether, benzoinisopropyl ether, and benzoinisobutyl ether; aromatic ketones such as benzyl, benzoin, benzophenone, and $\alpha$-hydroxy cyclohexyl phenyl ketone; aromatic ketals such as benzyl dimethyl ketal; and thioxanthones such as polyvinyl benzophenone, chlorothioxanthone, dodecylthioxanthone, dimethylthioxanthone, and diethylthioxanthone.

The compounding amount of the photopolymerization initiator is, for example, 0.1 to 20 parts by weight, or preferably about 0.5 to 10 parts by weight with respect to 100 parts by weight of the base polymer in the pressure-sensitive adhesive.

Each of the above-mentioned addition type and base polymer type, active energy ray-curable pressure-sensitive adhesives may further contain any appropriate additive such as a tackifier, an antioxidant, a filler, or a colorant in addition to any such component as described above as required.

When the external stimulus is heat, the pressure-sensitive adhesive layer can be formed of a thermosetting pressure-sensitive adhesive containing the base polymer and a thermosetting resin, or of a thermosetting pressure-sensitive adhesive containing the thermosetting resin as the base polymer. Any appropriate resin can be adopted as the thermosetting resin.

The pressure-sensitive adhesive layer formed of any such pressure-sensitive adhesive as described above preferably has high rupture resistance against elongation in a cured state. When the cured pressure-sensitive adhesive layer has high rupture resistance, a pressure-sensitive adhesive sheet for retaining elements having a crack-generating elongation of more than 115% can be obtained.

Any appropriate method can be adopted as a method of improving the rupture resistance of the pressure-sensitive adhesive layer after the curing. Examples of the method include: a method involving reducing the molecular weight of the base polymer in the above-mentioned pressure-sensitive adhesive; a method involving reducing the degree of cross-linking of the base polymer; a method involving adjusting the compounding amounts of the curable resin, the oligomer, and the monomer in the pressure-sensitive adhesive; a method involving adding a component that suppresses the generation of a crack to the pressure-sensitive adhesive; and a combination of two or more of these methods. Of those, the method involving adjusting the compounding amounts of the curable resin, the oligomer, and the monomer in the pressure-sensitive adhesive can be preferably employed. In general, reducing the molecular weight or degree of cross-linking of the base polymer tends to reduce the cohesive strength of the pressure-sensitive adhesive. Accordingly, the rupture resistance is improved, but sufficient adhesion cannot be obtained or the pressure-sensitive adhesive adheres to a chip that has been picked up in some cases. According to the method involving adjusting the compounding amounts of the curable resin and the like in the pressure-sensitive adhesive, however, even when a base polymer having a large molecular weight or large degree of cross-linking is used, a pressure-sensitive adhesive layer which exerts strong adhesion before its curing and which achieves a high level of compatibility between the light releasability and the rupture resistance after the curing can be obtained. It should be noted that a substance having a molecular weight of 1000 or less is preferred as the component that suppresses the generation of a crack, and for example, a plasticizer or surfactant having a molecular weight of 1000 or less can be used.

The above-mentioned pressure-sensitive adhesive layer has a thickness of preferably 1 to 50 $\mu$m, or more preferably 3 to 20 $\mu$m. As long as the thickness falls within the range, the pressure-sensitive adhesive sheet for retaining elements after the curing can be easily expanded. Accordingly, the expanding step can be performed without a hitch, and the elements can be strongly retained before the curing. On the other hand, when the thickness exceeds 50 $\mu$m, the expansion of the pressure-sensitive adhesive sheet for retaining elements after the curing requires a large strength. In addition, when the thickness is less than 1 $\mu$m, the elements cannot be retained with reliability in some cases. The pressure-sensitive adhesive layer may be a single layer, or may be a laminate of a plurality of layers.

Any appropriate method can be adopted as a method of laminating the base material layer and the pressure-sensitive adhesive layer described above. Examples of the method include: a method involving directly applying the above-mentioned pressure-sensitive adhesive onto the surface of the base material of which the base material layer is constituted; a method involving applying the above-mentioned pressure-sensitive adhesive onto the sheet onto which a releasing agent has been applied, drying the applied pressure-sensitive adhesive to form the pressure-sensitive adhesive layer, and transferring the resultant onto the base material; and a method involving applying the above-mentioned pressure-sensitive adhesive onto the sheet onto which the releasing agent has been applied, drying the applied pressure-sensitive adhesive to form the pressure-sensitive adhesive layer, and laminating the base material onto the pressure-sensitive adhesive layer.

D. Separator

The separator **13** has functions of, for example, the protection and smoothening of the surface of the pressure-sensitive adhesive layer, label processing, and blocking prevention. The separator can be appropriately provided when those functions are needed.

The separator can be formed of any appropriate forming material. Specific examples of the forming material include paper, and synthetic resin films such as polyethylene, polypropylene, and polyethylene terephthalate. The surface of the separator may be subjected to a releasing treatment with, for example, a silicone-, long-chain alkyl-,fluorine-,or molybdenumsulfide-based releasing agent as required in order that releasability from the pressure-sensitive adhesive layer may be improved. In addition, the surface maybe subjected to, for example, a UV protection treatment as required in order that the pressure-sensitive adhesive layer may be prevented from curing with ambient UV light.

The separator has a thickness of generally 10 to 200 $\mu$m, or preferably about 25 to 100 $\mu$m.

E. Usage of pressure-sensitive adhesive sheet for retaining elements

The above-mentioned pressure-sensitive adhesive sheet for retaining elements typically retains a plurality of chips in the expanding step and the pickup step. To be specific, the pressure-sensitive adhesive layer of the above-mentioned pressure-sensitive adhesive sheet for retaining elements is cured by an external stimulus before the sheet is expanded in a state of retaining the plurality of chips on its surface in order that a gap between the chips may be expanded. Next, the chips are picked up with a die bonder or the like in a state where the pressure-sensitive adhesive layer exerts its light releasability. In a preferred embodiment, the above-mentioned pressure-sensitive adhesive sheet for retaining elements functions as a pressure-sensitive adhesive sheet for dicing. That is, the chips can be recovered by: attaching and fixing a semiconductor wafer onto the above-mentioned pressure-sensitive adhesive sheet for retaining elements; performing dicing; curing the pressure-sensitive adhesive layer after the dicing; and expanding the pressure-sensitive adhesive sheet for retaining elements after the curing.

In the expanding step, the pressure-sensitive adhesive layer is preferably present at any gap between the plurality of chips. This is because the above-mentioned pressure-sensitive adhesive sheet for retaining elements can suitably exert a preventing effect on chip floating. For example, when the above-mentioned pressure-sensitive adhesive sheet for retaining elements is used as a pressure-sensitive adhesive sheet for dicing, the dicing is performed so that the pressure-sensitive adhesive layer may remain in a dicing line, and then the expanding step is performed by expanding the pressure-sensitive adhesive sheet, the pressure-sensitive adhesive layer is to be present at any gap between the plurality of chips in the expanding step. In addition, for example, when the plurality of chips that have already been subjected to the dicing are transferred onto the above-mentioned pressure-sensitive adhesive sheet for retaining elements before the expanding step is performed, the pressure-sensitive adhesive layer is to be present at any gap between the plurality of chips in the expanding step.

Any appropriate method can be adopted as a method for such dicing that the pressure-sensitive adhesive layer remains in a dicing line. Preferred specific examples of the method include: a scribing method involving cutting the wafer to a depth smaller than the thickness of the wafer and dividing the wafer to singulate the wafer into the chips; a laser dicing method involving processing the wafer by ablation with laser to singulate the wafer into the chips; and a stealth dicing method involving modifying the inside of the wafer by laser processing and expanding the pressure-sensitive adhesive sheet to divide the wafer. Of those, the laser dicing method is preferred because the method is suitable for fine dicing.

F. Method of producing elements

According to another aspect of the present invention, there is provided a method of producing elements. Preferred examples of the elements to be produced include semiconductor elements and semiconductor packages formed from silicon and gallium-arsenide. Hereinafter, an embodiment in which the elements are semiconductor elements is described in detail. However, any appropriate elements (e.g., various elements such as optical elements and piezoelectric elements formed from ruby, glass, and ceramics) can be produced by the production method of the present invention.

In a first embodiment, the method of producing elements of the present invention includes the steps of: attaching a substrate on which a plurality of elements have been formed to the surface of the pressure-sensitive adhesive layer of the above-mentioned pressure-sensitive adhesive sheet for retaining elements of the present invention (mounting step); subjecting the substrate to dicing to singulate the plurality of elements (dicing step); and expanding the pressure-sensitive adhesive sheet for retaining elements to expand a gap between the plurality of singulated elements (expanding step).

The mounting step is the step of attaching a semiconductor wafer having a plurality of semiconductor elements formed on its surface and the above-mentioned pressure-sensitive adhesive sheet for retaining elements. A method for the attachment is, for example, a method involving superimposing the semiconductor wafer and the above-mentioned pressure-sensitive adhesive sheet for retaining elements on each other so that the side of the pressure-sensitive adhesive layer may serve as an attachment surface and pressing the resultant with pressing means such as a pressure roller. Alternatively, the attachment can be performed by: superimposing the semiconductor wafer and the above-mentioned pressure-sensitive adhesive sheet for retaining elements on each other as described above in a pressurizable container such as an autoclave; and pressurizing the inside of the container. In this case, the wafer and the sheet may be attached while being pressed with any appropriate pressing means. Further, the wafer and the sheet can be attached in the same manner as in the foregoing in a vacuum chamber. A temperature upon attachment, which is not particularly limited, is preferably 20 to 80°C. Since the above-mentioned pressure-sensitive adhesive sheet for retaining elements before the curing of the pressure-sensitive adhesive layer can exert high adhesion, the semiconductor wafer can be easily and strongly attached in the mounting step.

The dicing step is the step of singulating the semiconductor wafer to produce the chips. Any appropriate method can be adopted as a dicing method. Such a dicing method that the pressure-sensitive adhesive layer remains in a dicing line can be preferably adopted. This is because the above-mentioned pressure-sensitive adhesive sheet for retaining elements can suitably exert a preventing effect on chip floating. Preferred examples of such dicing method include: a scribing method involving cutting the wafer to a depth smaller than the thickness of the wafer and dividing the wafer to singulate the wafer into the chips; a laser dicing method involving processing the wafer by ablation with laser to singulate the wafer into the chips; and a stealth dicing method involving modifying the inside of the wafer by laser processing and expanding the pressure-sensitive adhesive sheet to divide the wafer. Of those, the laser dicing method is preferred because the method is suitable for fine dicing.

The expanding step is the step of expanding the above-mentioned pressure-sensitive adhesive sheet for retaining elements to expand a gap between the chips. When each gap between the chips is expanded, the chips can be easily picked up. The expansion of the pressure-sensitive adhesive sheet for retaining elements is typically performed by applying a tension in a radial direction of the sheet. For example, the expansion of the pressure-sensitive adhesive sheet for retaining elements can be performed by pulling down a peripheral portion of the pressure-sensitive adhesive sheet fixed with a dicing ring in a predetermined amount in the radial direction with an expand ring. The pull-down amount is about 1 to 50 mm in ordinary cases, or is preferably about 1 to 30 mm. Since the above-mentioned pressure-sensitive adhesive sheet for retaining elements has a crack-generating elongation of more than 115%, the generation of a crack upon expansion in the surface of the pressure-sensitive adhesive layer, or especially the surface of the pressure-sensitive adhesive layer at a gap portion between the chips can be avoided. As a result, the pressure-sensitive adhesive sheet for retaining elements is uniformly expanded, and a large deformation can be prevented from occurring locally owing to the concentration of a stress. Accordingly, the phenomenon in which the chips are released from the surface of the pressure-sensitive adhesive layer to float can be prevented.

In the production method of the first embodiment, an external stimulus such as irradiation with active energy rays or heating is applied to the pressure-sensitive adhesive layer of the pressure-sensitive adhesive sheet for retaining elements described above during a time period after the dicing step and before the expanding step. As a result, the pressure-sensitive adhesive layer is cured, and its adhesion can significantly reduce. Accordingly, the chips can be easily released from the pressure-sensitive adhesive sheet for retaining elements. Conditions for the irradiation with active energy rays such as an irradiation intensity and an irradiation time, or conditions for the heating such as a heating time and a heating temperature can be appropriately set depending on purposes and the like.

In a second embodiment, the method of producing elements of the present invention includes the steps of: transferring a plurality of elements that have already been singulated onto the surface of the pressure-sensitive adhesive layer of the above-mentioned pressure-sensitive adhesive sheet for retaining elements of the present invention (transferring step); and expanding the pressure-sensitive adhesive sheet for retaining elements to expand a gap between the plurality of singulated elements (expanding step) . The transferring step and the expanding step may each be repeatedly performed at least twice. Repeatedly performing each of those steps can additionally expand each gap between the elements.

The transferring step is the step of transferring and attaching the plurality of elements that have already been singulated by dicing onto the above-mentioned pressure-sensitive adhesive sheet for retaining elements. Any appropriate method can be adopted as a method for the transfer. For example, a semiconductor wafer is attached and fixed onto any appropriate pressure-sensitive adhesive sheet for dicing, and then dicing is performed. The pressure-sensitive adhesive sheet for dicing and the above-mentionedpressure-sensitive adhesive sheet for retaining elements are attached so as to sandwich the resultant chips. Next, the pressure-sensitive adhesive sheet for dicing is released. As a result, the plurality of chips are transferred onto the above-mentioned pressure-sensitive adhesive sheet for retaining elements. The attachment can be performed with pressing means such as a pressure roller.

The chips to be transferred have only to be singulated by any appropriate dicing method, and may be, for example, chips subjected to dicing according to such a mode that the pressure-sensitive adhesive layer is completely cut as illustrated in FIG. **3B.**

The description of the expanding step is omitted because the step is the same as the expanding step in the first embodiment described above.

In the production method of the second embodiment, an external stimulus such as irradiation with active energy rays or heating is applied to the pressure-sensitive adhesive layer of the pressure-sensitive adhesive sheet for retaining elements described above during a time period after the transferring step and before the expanding step. As a result, the pressure-sensitive adhesive layer is cured, and its adhesion can significantly reduce. Accordingly, the chips can be easily released and recovered from the pressure-sensitive adhesive sheet for retaining elements. Conditions for the irradiation with active energy rays such as an irradiation intensity and an irradiation time, or conditions for the heating such as a heating time and a heating temperature can be appropriately set depending on purposes and the like.

The production methods of the first and second embodiments each typically include the step of picking up the chips after the expanding step. The pickup step is the step of releasing the chips retained on the surface of the expanded pressure-sensitive adhesive sheet for retaining elements described above. Any appropriate method can be adopted as a method for the pickup. An example of the method is a method involving thrusting each chip with a needle from the side of the pressure-sensitive adhesive sheet and picking up the thrust chip with a pickup apparatus. Since the above-mentioned pressure-sensitive adhesive sheet for retaining elements suppresses the release of the chips in the expanding step, the scattering of the chips due to an impact at the time of the pickup can be prevented.

The elements may be produced by combining the production method of the first embodiment and the production method of the second embodiment described above as required. To be specific, in the method of producing elements of the present invention, the transferring step and the expanding step can each be performed one to several times during a time period after the performance of the mounting step, the dicing step, and the expanding step described above and before the performance of the pickup step.

Hereinafter, the present invention is described specifically by way of examples. However, the present invention is by no means limited to these examples. It should be noted that measurement methods in the examples and the like are as described below.

[Method of measuring crack-generating elongation]

A sample (70 mm×20 mm) was mounted on a universal tensile tester (manufactured by ORIENTEC, product name "RTC-1150A") so that a chuck-to-chuck distance might be 20 mm. The sample was pulled at room temperature and a tension speed of 50 mm/min until a crack was generated. The length of the pressure-sensitive adhesive sheet upon generation of the crack was measured. The measurement was repeated twice, and then a crack-generating elongation was determined by using the average of the measured values from the following equation.

Crack-generating elongation (%)=[(the length of the pressure-sensitive adhesive sheet when a crack is generated in the surface of the pressure-sensitive adhesive layer)-(the original length of the pressure-sensitive adhesive sheet)]/(the original length of the pressure-sensitive adhesive sheet)×100

In the above-mentioned measurement of the crack-generating elongation, the pressure-sensitive adhesive sheet was continuously observed with the eyes during the elongation of the pressure-sensitive adhesive sheet with the universal tensile tester. As a result, a line substantially perpendicular to the pulling direction appeared in the surface of the pressure-sensitive adhesive sheet (surface of the pressure-sensitive adhesive layer). Since the substantially perpendicular line was the crack generated in the surface of the pressure-sensitive adhesive layer, the length of the pressure-sensitive adhesive sheet when the observation of a state where the line reached both sides stretching in the direction in which the pressure-sensitive adhesive sheet was pulled was attained was measured as the length of the pressure-sensitive adhesive sheet when the crack was generated in the surface of the pressure-sensitive adhesive layer.

[Method of measuring weight-average molecular weight]

The weight-average molecular weight of a synthesized acrylic polymer was measured by the following method. In other words, the synthesized acrylic polymer was dissolved in tetrahydrofuran (THF) so that its concentration might be 0 . 1 wt%. Then, the weight-average molecular weight was measured by gel permeation chromatography (GPC) in terms of polystyrene. Conditions for the measurement are as described below.

| | |
|---|---|
| GPC apparatus: | HLC-8120GPC (manufactured by TOSOH CORPORATION) |
| Column: | (GMHHR-H)+(GMHHR-H)+(G2000HHR) |
| | (manufactured by TOSOH CORPORATION) |
| Flow rate: | 0.8 ml/min |
| Concentration: | 0.1 wt% |

(continued)

| | |
|---|---|
| Injection amount: | 100 $\mu$l |
| Column temperature: | 40°C |
| Eluent: | THF |

[Production Example 1]

Production of acrylic polymer A

Butyl acrylate, ethyl acrylate, and 2-hydroxyethyl acrylate were copolymerized according to the composition "butyl acrylate:ethyl acrylate:2-hydroxyethyl acrylate=50:50:20 (weight ratio)." Thus, an acrylic polymer having hydroxyl groups at its side chains was obtained. Next, 60% of the hydroxyl groups derived from 2-hydroxyethyl acrylate of the acrylic polymer were bonded to 2-methacryloyloxyethyl isocyanate (2-isocyanatoethyl methacrylate). Thus, an acrylic polymer A having methacrylate groups at its side chains was produced. The resultant acrylic polymer A had a weight-average molecular weight of 400,000 in terms of polystyrene.

[Production Example 2]

Production of acrylic polymer B

An acrylic polymer B was produced by copolymerizing 2-ethylhexyl acrylate, methyl acrylate, and acrylic acid according to the composition "2-ethylhexyl acrylate:methyl acrylate:acrylic acid=30:70:10 (weight ratio)." The resultant acrylic polymer B had a weight-average molecular weight of 800, 000 in terms of polystyrene.

[Example 1]

First, 100 parts by weight of the acrylic polymer B obtained in Production Example 2, 35 parts by weight of dipentaerythritol hexaacrylate (DPHA: manufactured by Nippon Kayaku Co., Ltd.) as an active energy ray-curable monomer, 3.5 parts by weight of a cross-linking agent (manufactured by Nippon Polyurethane Industry Co., Ltd., trade name "Coronate L"), and 5 parts by weight of a photopolymerization initiator (manufactured by Ciba-Geigy, trade name "IRGACURE 651") were dissolved in toluene. Thus, a polymer solution was obtained. The resultant polymer solution was applied onto a separator (film obtained by subjecting a PET#38 to a silicone releasing treatment) with an applicator. After that, volatile components such as the solvent were removed by drying. Thus, a laminate in which an active energy ray-curable pressure-sensitive adhesive layer having a thickness of 20 $\mu$m was provided on the separator was obtained. A film obtained by subjecting an ethylene-vinyl acetate copolymer to extrusion molding (vinylacetate content: 9 wt%, thickness: 115 $\mu$m) was laminated with a hand roller by regarding the side of the pressure-sensitive adhesive layer of the laminate as a base material. Thus, apressure-sensitive adhesive sheet 1 for retaining elements (thickness of the pressure-sensitive adhesive layer: 20 $\mu$m) was obtained.

[Example 2]

A pressure-sensitive adhesive sheet 2 for retaining elements (thickness of the pressure-sensitive adhesive layer: 20 $\mu$m) was obtained in the same manner as in Example 1 except that a polymer solution was obtained by dissolving 100 parts by weight of the acrylic polymer B obtained in Production Example 2, 35 parts by weight of an active energy ray-curable oligomer (manufactured by The Nippon Synthetic Chemical Industry Co. , Ltd. , trade name "SHIKOH UV-1700B"), 3. 5 parts by weight of a cross-linking agent (manufactured by Nippon Polyurethane Industry Co., Ltd., trade name "Coronate L"), and 5 parts by weight of a photopolymerization initiator (manufactured by Ciba-Geigy, trade name "IRGACURE 651") in toluene.

[Example 3]

A pressure-sensitive adhesive sheet 3 for retaining elements (thickness of the pressure-sensitive adhesive layer: 20 $\mu$m) was obtained in the same manner as in Example 1 except that a polymer solution was obtained by dissolving 100 parts by weight of the acrylic polymer B obtained in Production Example 2, 25 parts by weight of an active energy ray-curable oligomer (manufactured by The Nippon Synthetic Chemical Industry Co. , Ltd. , trade name "SHIKOH UV-1700B"), 3. 5 parts by weight of a cross-linking agent (manufactured by Nippon Polyurethane Industry Co., Ltd., trade name "Coronate L"), and 5 parts by weight of a photopolymerization initiator (manufactured by Ciba-Geigy, trade name "IRGACURE 651") in toluene.

[Comparative Example 1]

A pressure-sensitive adhesive sheet Cl (thickness of the pressure-sensitive adhesive layer: 20 $\mu$m) was obtained in the same manner as in Example 1 except that a polymer solution was obtained by dissolving 100 parts by weight of the acrylic polymer A obtained in Production Example 1, 5 parts by weight of an active energy ray-curable oligomer (manufactured by The Nippon Synthetic Chemical Industry Co. , Ltd. , trade name "SHIKOH UV-1700B"), 1 parts by weight of a cross-linking agent (manufactured by Nippon Polyurethane Industry Co., Ltd., trade name "Coronate L"), and 5 parts by weight of a photopolymerization initiator (manufactured by Ciba-Geigy, trade name "IRGACURE 651") in toluene.

[Comparative Example 2]

A pressure-sensitive adhesive sheet C2 (thickness of the pressure-sensitive adhesive layer: 20 $\mu$m) was obtained in the same manner as in Example 1 except that a polymer solution was obtained by dissolving 100 parts by weight of the acrylic polymer A obtained in Production Example 1, 1 parts by weight of a cross-linking agent (manufactured by Nippon Polyurethane Industry Co., Ltd., trade name "Coronate L"), and 5 parts by weight of a photopolymerization initiator (manufactured by Ciba-Geigy, trade name "IRGACURE 651") in toluene.

The pressure-sensitive adhesive sheet obtained in each of the above-mentioned examples and comparative examples was cut into a piece measuring 70 mm by 20 mm with a sharp cutter so that a chip or the like might not be generated in a side surface of the sheet. Then, irradiation with UV light was performed in a state where the separator was provided from the side of the base material under the following conditions. After that, the separator was released, and the remainder was subjected to the above-mentioned measurement of a crack-generating elongation. Table 1 shows the result.

<Conditions for irradiation with UV light>

|  |  |
|---|---|
| Apparatus: | An apparatus available under the trade name "NEL UM-810" from NITTO SEIKI CO., Ltd. |
| UV light illuminance: | 20 mW/cm$^2$ |
| UV light quantity: | 500 mJ/cm$^2$ |

The following steps were performed by using the pressure-sensitive adhesive sheet obtained in each of the above-mentioned examples and comparative examples, and the presence or absence of a crack in the pressure-sensitive adhesive layer, and the presence or absence of chip floating at the time of the expansion of the pressure-sensitive adhesive sheet were observed.

[Mounting step]

A pressure-sensitive adhesive sheet for dicing (manufactured by Nitto Denko Corporation, trade name "ELEP HOLDER DU-300," polyolefin base material, sheet thickness: 85 $\mu$m) was attached to the mirror surface of a 4-inch silicon wafer (thickness: 200 $\mu$m) with a hand roller. Thus, a work for dicing was obtained.

[Dicing step]

The resultant work for dicing was turned into chips by being subjected to dicing under the following conditions. Thus, a work with chips was obtained.

<Dicing conditions>

|  |  |
|---|---|
| Apparatus: | An apparatus available under the trade name "DFD-651" from DISCO Corporation |

(continued)

| | |
|---|---|
| Dicing blade: | A blade available under the trade name "NBC-ZH2050 27HECC" from DISCO Corporation |
| Dicing speed: | 80 mm/sec |
| Number of revolutions of blade: | |
| | 40,000 rpm |
| Blade height: | 50 $\mu$m |
| Cutting water quantity: | 1 L/min |
| Chip size: | 1 mm$\times$1 mm |

The resultant work with chips was irradiated with UV light from the side of the pressure-sensitive adhesive sheet for dicing under the following conditions.

<Conditions for irradiation with UV light>

| | |
|---|---|
| Apparatus: | An apparatus available under the trade name "NEL UM-810" from NITTO SEIKI CO., Ltd. |
| UV light illuminance: | 20 mW/cm$^2$ |
| UV light quantity: | 500 mJ/cm$^2$ |

[Transferring step]

The pressure-sensitive adhesive sheet obtained in each of the above-mentioned examples and comparative examples was attached to the surface of the above-mentioned work with chips where the chips were retained with a hand roller. Next, the pressure-sensitive adhesive sheet for dicing was released. Thus, a work with chips for expansion was obtained.

[Expanding step]

The resultant work with chips for expansion was immediately attached to a 6-inch dicing ring (manufactured by DISCO Corporation, model "DTF 2-6-1"), and then the resultant was left to stand at room temperature for 30 minutes. After that, irradiation with UV light was performed under conditions identical to those of the pressure-sensitive adhesive sheet for dicing described above so that the pressure-sensitive adhesive layer might be cured. Next, the ring was fixed onto the stage of a manual expander, and then the pressure-sensitive adhesive sheet was pulled down by 20 mm. Thus, the pressure-sensitive adhesive sheet was expanded.

[Observation of crack in pressure-sensitive adhesive layer and chip floating]

The surface of each pressure-sensitive adhesive sheet that had undergone the expanding step was observed with a microscope (at a magnification of 100). Thus, the presence or absence of a crack in the pressure-sensitive adhesive layer at a gap between chips was observed. In addition, the back surface of each pressure-sensitive adhesive sheet was observed with a microscope (at a magnification of 100), and the case where chip floating reached a site distant from a side of a chip by 200 $\mu$m or more was regarded as the "presence" of chip floating (for example, in FIG. 4, two regions surrounded by the left and right sides of a chip and dotted lines each illustrate a range where the chip floats from the surface of the pressure-sensitive adhesive layer, and in this case, a distance **a** from a side of the chip to the portion where the floating progresses to the largest extent of 200 $\mu$m or more is regarded as the "presence" of chip floating and a distance **a** of less than 200 $\mu$m is regarded as the "absence" of chip floating). Table 1 shows the results.

[Table 1]

| | Crack-generating elongation | Presence or absence of crack | Presence or absence of chip floating |
|---|---|---|---|
| Comparative Example 1 | 84% | Present | Present |
| Comparative Example 2 | 110% | Present | Present |

(continued)

| | Crack-generating elongation | Presence or absence of crack | Presence or absence of chip floating |
|---|---|---|---|
| Example 1 | 117% | Absent | Absent |
| Example 2 | 163% | Absent | Absent |
| Example 3 | 239% | Absent | Absent |

As shown in Table 1, in each of all the pressure-sensitive adhesive sheets 1 to 3 for retaining elements of the examples, no crack was observed in the surface of the pressure-sensitive adhesive layer at a gap between the chips, and no chip floating was observed either. In contrast, in each of the pressure-sensitive adhesive sheets C1 and C2 of the comparative examples each having a crack-generating elongation of less than 115%, a crack was observed in the surface of the pressure-sensitive adhesive layer at a gap between the chips, and chip floating occurred in association with the crack.

The pressure-sensitive adhesive sheet for retaining elements of the present invention can be suitably used in the production of various elements, or typically semiconductor elements including the expanding step.

**Claims**

1. A pressure-sensitive adhesivesheetfor retaining elements, the pressure-sensitive adhesive sheet comprising:

a base material layer; and
a pressure-sensitive adhesive layer provided on the base material layer and capable of being cured by an external stimulus,
wherein a crack-generating elongation represented by the following equation in a case where the pressure-sensitive adhesive sheet is elongated in a state where the pressure-sensitive adhesive layer is cured is larger than 115%:

Crack-generating elongation (%)=[(a length of the pressure-sensitive adhesive sheet when a crack is generated in a surface of the pressure-sensitive adhesive layer)-(an original length of the pressure-sensitive adhesive sheet)]/(the original length of the pressure-sensitive adhesive sheet)×100.

2. A pressure-sensitive adhesive sheet for retaining elements according to claim 1, wherein the pressure-sensitive adhesive layer comprises an active energy ray-curable pressure-sensitive adhesive layer.

3. A pressure-sensitive adhesive sheet for retaining elements according to claim 2, wherein a material of which the pressure-sensitive adhesive layer is formed contains a base polymer, and 1 to 150 parts by weight of at least one of an active energy ray-curable monomer and an active energy ray-curable oligomer with respect to 100 parts by weight of the base polymer.

4. A pressure-sensitive adhesive sheet for retaining elements according to claim 2, wherein a material of which the pressure-sensitive adhesive layer is formed contains a (meth)acrylic polymer having a polymerizable carbon-carbon double bond.

5. A pressure-sensitive adhesive sheet for retaining elements according to claim 1, wherein the pressure-sensitive adhesive sheet is used for retaining a plurality of singulated elements in an expanding step.

6. A pressure-sensitive adhesive sheet for retaining elements according to claim 5, wherein the pressure-sensitive adhesive layer is present at a gap between the plurality of singulated elements.

7. Apressure-sensitive adhesive sheet for retaining elements according to claim 5, wherein the elements comprise elements singulated by laser dicing.

8. A pressure-sensitive adhesive sheet for retaining elements according to claim 5, wherein the elements comprise elements transferred after the singulation.

9. A pressure-sensitive adhesive sheet for retaining elements according to claim 1, wherein the elements comprise semiconductor elements.

10. A method of producing elements, comprising:

attaching a substrate on which a plurality of elements have been formed to the surface of the pressure-sensitive adhesive layer of the pressure-sensitive adhesive sheet for retaining elements according to claim 1;
subjecting the substrate to dicing to singulate the plurality of elements; and
expanding the pressure-sensitive adhesive sheet for retaining elements to expand a gap between the plurality of singulated elements.

11. A method of producing elements according to claim 10, wherein the dicing comprises laser dicing.

12. A method of producing elements according to claim 10, wherein the elements comprise semiconductor elements.

13. A method of producing elements, comprising:

transferring a plurality of elements that have already been singulated onto the surface of the pressure-sensitive adhesive layer of the pressure-sensitive adhesive sheet for retaining elements according to claim 1; and
expanding the pressure-sensitive adhesive sheet for retaining elements to expand a gap between the plurality of singulated elements.

14. A method of producing elements according to claim 13, wherein the elements comprise semiconductor elements.

Fig.1

<u>100</u>

Fig. 2

Fig. 3A

Fig. 3B

14

12

11

14

12

11

Fig. 4

a

Europäisches
Patentamt

European
Patent Office

Office européen
des brevets

## EUROPEAN SEARCH REPORT

Application Number

EP 10 17 7518

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 033 996 A1 (NITTO DENKO CORP [JP]) 11 March 2009 (2009-03-11) * claims 1-14; figure 1; examples 1,2 * ----- | 1-14 | INV. C09J7/02 |
| X | EP 1 942 166 A1 (NITTO DENKO CORP [JP]) 9 July 2008 (2008-07-09) * claims 1,2; examples 1-16 * ----- | 1-14 | |

TECHNICAL FIELDS
SEARCHED        (IPC)

C09J

The present search report has been drawn up for all claims

| Place of search | Date of completion of the search | Examiner |
|---|---|---|
| Munich | 26 January 2011 | Sperry, Pascal |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 10 17 7518

This annex lists the patent family members relating to the patent documents cited in the above-mentioned European search report.
The members are as contained in the European Patent Office EDP file on
The European Patent Office is in no way liable for these particulars which are merely given for the purpose of information.

26-01-2011

| Patent document cited in search report | | | Publication date | | Patent family member(s) | | Publication date |
|---|---|---|---|---|---|---|---|
| EP 2033996 | A1 | 11-03-2009 | | CN | 101381587 | A | 11-03-2009 |
| | | | | JP | 2009064975 | A | 26-03-2009 |
| | | | | KR | 20090026094 | A | 11-03-2009 |
| | | | | US | 2009065133 | A1 | 12-03-2009 |
| EP 1942166 | A1 | 09-07-2008 | | CN | 101215448 | A | 09-07-2008 |
| | | | | JP | 2008166651 | A | 17-07-2008 |
| | | | | KR | 20080064744 | A | 09-07-2008 |
| | | | | US | 2008261038 | A1 | 23-10-2008 |

EPO FORM P0459

For more details about this annex : see Official Journal of the European Patent Office, No. 12/82

**EP 2 305 763 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP HEI616524 B
- JP HEI7105367 B
- JP 2005235795 A